# EUROPEAN PATENT APPLICATION

(11) **EP 4 749 934 A1**
(43) Date of publication of application: **27.05.2026**
(21) Application number: 24842127.3
(22) Date of filing: 16.06.2024
(51) Int. Cl.: H04B 1/40, H03F 1/30

(54) **RADIO FREQUENCY FRONT-END MODULE FOR OPTIMIZING DYNAMIC ERROR VECTOR MAGNITUDE AND ELECTRONIC DEVICE**

(30) Priority: 18.07.2023 CN 202310880464
(71) Applicant: Vanchip (Tianjin) Technology Co. Ltd, Tianjin 300457 (CN)
(72) Inventor: LI, Hao, Tianjin 300457 (CN); ZHANG, Jun, Tianjin 300457 (CN); CHEN, Lufeng, Tianjin 300457 (CN); LI, Junfeng, Tianjin 300457 (CN)
(74) Representative: Wang, Bo
(86) International application number: PCT/CN2024/099469
(87) International publication number: WO 2025/016128

(57) **Abstract**

Disclosed in the present invention is a radio frequency front-end module for optimizing dynamic error vector magnitude, comprising at least one transmitting channel. Each transmitting channel comprises a driving amplifier, a first bias circuit, a first dynamic power supply, a power amplifier, a second bias circuit, a second dynamic power supply, a logic circuit and a TX timer; upon receiving a TX instruction, the logic circuit controls the transmitting channel to enter a TX working mode, and the TX timer starts timing; and on the basis of a plurality of set time periods, at least one of the first dynamic power supply and the second dynamic power supply outputs dynamic power supply voltages that sequentially increase or decrease, and provides the dynamic power supply voltages to the first bias circuit and/or the second bias circuit, so as to dynamically compensate for the output power change caused by the temperature change of a circuit, ensuring that the dynamic error vector magnitude meets higher requirements.

## Description

### BACKGROUND

### Technical Field

The present invention relates to a radio frequency front-end module for optimizing a dynamic error vector magnitude (DEVM), also relates to an electronic device including the radio frequency front-end module, and relates to the technical field of radio frequency integrated circuits.

### Related Art

With the rapid development of communications technologies, in a next-generation standard of WiFi 6, i.e., WiFi 7, the technologies such as 320M channel bandwidth, QAM modulation, and MIMO transmission are introduced based on the WiFi 6, so that the transmission rate of the WiFi 7 is greatly improved, and a maximum data transmission rate reaches an amazing value of 46 Gbps, which is 4.8 times that of the WiFi 6. A 4096-QAM modulation technology supported by the WiFi 7 has a quite high requirement, up to -38 dB, on a DEVM of a signal, and a packet length of the signal also reaches 4 ms, 6 ms, or even 10 ms. A longer packet length of a signal indicates a larger time period or a larger duty ratio of TX transmission, so that a temperature change of a power amplifier (PA) is more significant. Therefore, a requirement on temperature compensation of the PA also becomes increasingly high.

Currently, the requirement by a typical communications platform on the DEVM of a radio frequency front-end module is -47 dB, which means that in a time division duplexing working mode, the PA needs to control a magnitude change within a TX working cycle to be 0.05 dB. In addition, there are requirements on the duty ratio of TX transmission from 10% to 90%. For TX transmission with different duty ratios, requirements on the temperature compensation are also different. In the existing technology, the temperature compensation is usually performed by optimizing a layout, or a current or a voltage is reduced to reduce a junction temperature. However, these technical means cause many impacts on a temperature compensation effect, and consequently, a change in output power is apt to exceeding 0.1 dB, causing degradation of the DEVM.

### SUMMARY

A first technical problem to be resolved by the present invention is to provide a radio frequency front-end module for optimizing a dynamic error vector magnitude.

Another technical problem to be resolved by the present invention is to provide an electronic device including the radio frequency front-end module.

To achieve the foregoing objective, the present invention adopts the following technical solutions:
According to a first aspect of the embodiments of the present invention, a radio frequency front-end module for optimizing a dynamic error vector magnitude is provided, including at least one transmit channel, where each transmit channel includes:
a driving amplifier, configured to perform gain amplification on an input radio frequency signal, an input end of the driving amplifier being connected to a radio frequency signal input end, and an output end of the driving amplifier being connected to an input end of a power amplifier;
a first bias circuit, configured to provide a bias voltage to the driving amplifier, an output end of the first bias circuit being connected to a bias end of the driving amplifier;
a first dynamic power supply, configured to provide a power supply voltage for the first bias circuit, and an output end of the first dynamic power supply being connected to a power supply end of the first bias circuit;
a power amplifier, configured to perform power amplification on a radio frequency signal, an output end of the power amplifier being connected to a radio frequency signal output end;
a second bias circuit, configured to provide a bias voltage to the power amplifier, an output end of the second bias circuit being connected to a bias end of the power amplifier;
a second dynamic power supply, configured to provide a power supply voltage for the second bias circuit, an output end of the second dynamic power supply being connected to a power supply end of the second bias circuit;
a logic circuit, configured to generate a logic control signal according to a received baseband control signal to control a working status of a related unit; an input end of the logic circuit being connected to an input end of the baseband control signal, and an output end of the logic circuit being connected to a control end of a TX timer;
the TX timer, configured to record a TX working time, where
upon receiving a TX instruction, the logic circuit controls the transmit channel to enter a TX working mode, and the TX timer starts timing, and when a first time, a second time, a third time, ..., and an n^{th} time are respectively reached, at least one dynamic power supply of the first dynamic power supply and the second dynamic power supply sequentially outputs a first voltage, a second voltage, a third voltage, ..., and an n^{th} voltage respectively, to the first bias circuit and/or the second bias circuit, to dynamically compensate for a change in output power caused by a temperature change of the circuit, where n is a positive integer.

Preferably, an output end of the TX timer is separately connected to control ends of the first dynamic power supply and the second dynamic power supply.

Preferably, when the output power decreases as the TX working time increases, at least one dynamic power supply of the first dynamic power supply and the second dynamic power supply sequentially outputs ascending first voltage, second voltage, third voltage, ..., and n^{th} voltage to the first bias circuit and/or the second bias circuit during a first time, a second time, a third time, ..., and an n^{th} time, respectively.

Preferably, when the output power increases as the TX working time increases, at least one dynamic power supply of the first dynamic power supply and the second dynamic power supply sequentially outputs descending first voltage, second voltage, third voltage, ..., and n^{th} voltage to the first bias circuit and/or the second bias circuit during a first time, a second time, a third time, ..., and an n^{th} time, respectively.

Preferably, the transmit channel further includes a voltage detection circuit, an input end of the transmit channel being connected to a power supply VDD; and an output end of the transmit channel being separately connected to the logic circuit and the TX timer.

Preferably, when a voltage of the power supply VDD is higher than a first threshold, the output power decreases as the TX working time increases; and an output voltage of at least one dynamic power supply of the first dynamic power supply and the second dynamic power supply sequentially ascends as the TX working time increases, to be provided to the first bias circuit and/or the second bias circuit; and
when the voltage of the power supply VDD is lower than a second threshold, the output power increases as the TX working time increases; and the output voltage of the at least one dynamic power supply of the first dynamic power supply and the second dynamic power supply sequentially descends as the TX working time increases, to be provided to the first bias circuit and/or the second bias circuit.

Preferably, the transmit channel further includes a TX duty ratio detection circuit, separately connected to the logic circuit and the TX timer; and configured to detect a duty ratio of TX transmission in a TDD working mode.

Preferably, when a TX duty ratio detected by the TX duty ratio detection circuit is less than a third threshold, a compensation magnitude by which the output voltage of the at least one dynamic power supply of the first dynamic power supply and the second dynamic power supply that sequentially ascends or descends as the TX working time increases is greater; and
when the TX duty ratio detected by the TX duty ratio detection circuit is higher than a fourth threshold, the compensation magnitude by which the output voltage of the at least one dynamic power supply of the first dynamic power supply and the second dynamic power supply that sequentially ascends or descends as the TX working time increases is smaller.

Preferably, the transmit channel further includes a non-TX timer, respectively connected to the logic circuit and the TX timer, and configured to record a time of a non-TX working state.

Preferably, when the time of the non-TX working state recorded by the non-TX timer is less than a fifth threshold, the compensation magnitude by which the output voltage of the at least one dynamic power supply of the first dynamic power supply and the second dynamic power supply that sequentially ascends or descends as the TX working time increases is smaller; and
when the time of the non-TX working state recorded by the non-TX timer is higher than a sixth threshold, the compensation magnitude by which the output voltage of the at least one dynamic power supply of the first dynamic power supply and the second dynamic power supply that sequentially ascends or descends as the TX working time increases is larger.

Preferably, the first bias circuit and the second bias circuit in the transmit channel respectively use a first dynamic bias circuit and a second dynamic bias circuit; and
an output end of the TX timer is separately connected to control ends of the first dynamic bias circuit and the second dynamic bias circuit.

Preferably, when the output power decreases or increases as the TX working time increases, the logic circuit sends a control signal by using the TX timer, to control at least one dynamic bias circuit of the first dynamic bias circuit and the second dynamic bias circuit, to output a bias current or voltage that sequentially ascends or descends as the TX working time increases.

According to a second aspect of the embodiments of the present invention, an electronic device is provided, the electronic device including the foregoing radio frequency front-end module for optimizing a dynamic error vector magnitude.

Compared with the existing technology, according to the radio frequency front-end module for optimizing a dynamic error vector magnitude provided in the present invention, dynamic compensation is performed, by using a technical solution of dynamic voltage compensation, for a change in the output power caused by a temperature change within a PA working cycle, thereby ensuring that the DEVM meets the requirements of the WiFi 7. In addition, the problem that temperature compensation requirements are inconsistent due to different PA temperature changes in different packages, different layouts, different voltages, and different TX duty ratios is resolved, thereby shortening a product research and development cycle. Therefore, the radio frequency front-end module for optimizing a dynamic error vector magnitude provided in the present invention has beneficial effects such as skillful and proper structural design, low design costs, and excellent circuit performance.

### BRIEF DESCRIPTION OF THE DRAWINGS

FIG. 1 is a schematic structural diagram of a typical radio frequency front-end module in the existing technology;
FIG. 2 is a schematic diagram of a power supply of a bias circuit providing a constant voltage in the existing technology;
FIG. 3 is a schematic diagram of output power changing over time in a TX working state in the existing technology;
FIG. 4 is a schematic structural diagram of a radio frequency front-end module for optimizing a dynamic error vector magnitude according to a first embodiment of the present invention;
FIG. 5 is a schematic diagram of a power supply of a bias circuit providing a dynamically ascending bias voltage when output power decreases as a TX working time increases according to the first embodiment of the present invention;
FIG. 6 is a schematic diagram of a power supply of a bias circuit providing a dynamically descending bias voltage when output power increases as a TX working time increases according to the first embodiment of the present invention;
FIG. 7 is a schematic diagram of the output power changing over time after a power supply of a bias circuit is dynamically compensated according to the first embodiment of the present invention;
FIG. 8 is a schematic structural diagram of a radio frequency front-end module for optimizing a dynamic error vector magnitude according to a second embodiment of the present invention;
FIG. 9 is a schematic diagram of a variation situation of the output power as a TX working time increases when a voltage of a power supply VDD is different according to the second embodiment of the present invention;
FIG. 10 is a schematic diagram of a dynamic compensation situation of a power supply of a bias circuit when the voltage of the power supply VDD is different according to the second embodiment of the present invention;
FIG. 11 is a schematic structural diagram of a radio frequency front-end module for optimizing a dynamic error vector magnitude according to a third embodiment of the present invention;
FIG. 12 is a schematic diagram of a dynamic compensation situation of a bias circuit power supply providing a power supply when a duty ratio is small or large in a case that output power decreases as a TX working time increases according to the third embodiment of the present invention;
FIG. 13 is a schematic diagram of a dynamic compensation situation of a bias circuit power supply providing a power supply when a duty ratio is small or large in a case that output power increases as a TX working time increases according to the third embodiment of the present invention;
FIG. 14 is a schematic structural diagram of a radio frequency front-end module for optimizing a dynamic error vector magnitude according to a fourth embodiment of the present invention;
FIG. 15 is a schematic diagram of a dynamic compensation situation of a bias circuit power supply providing a power supply when a non-TX working time is small or large in a case that output power decreases as a TX working time increases according to the fourth embodiment of the present invention;
FIG. 16 is a schematic diagram of a dynamic compensation situation of a bias circuit power supply providing a power supply when a non-TX working time is small or large in a case that output power increases as a TX working time increases according to the fourth embodiment of the present invention;
FIG. 17 is a schematic structural diagram of a radio frequency front-end module for optimizing a dynamic error vector magnitude according to a fifth embodiment of the present invention;
FIG. 18 is a schematic structural diagram of a first dynamic bias circuit and a second dynamic bias circuit according to the fifth embodiment of the present invention; and
FIG. 19 is a schematic diagram of an electronic device using a radio frequency front-end module for optimizing a dynamic error vector magnitude according to the present invention.

### DETAILED DESCRIPTION

The technical content of the present invention will be described in detail below with reference to the accompanying drawings and specific embodiments.

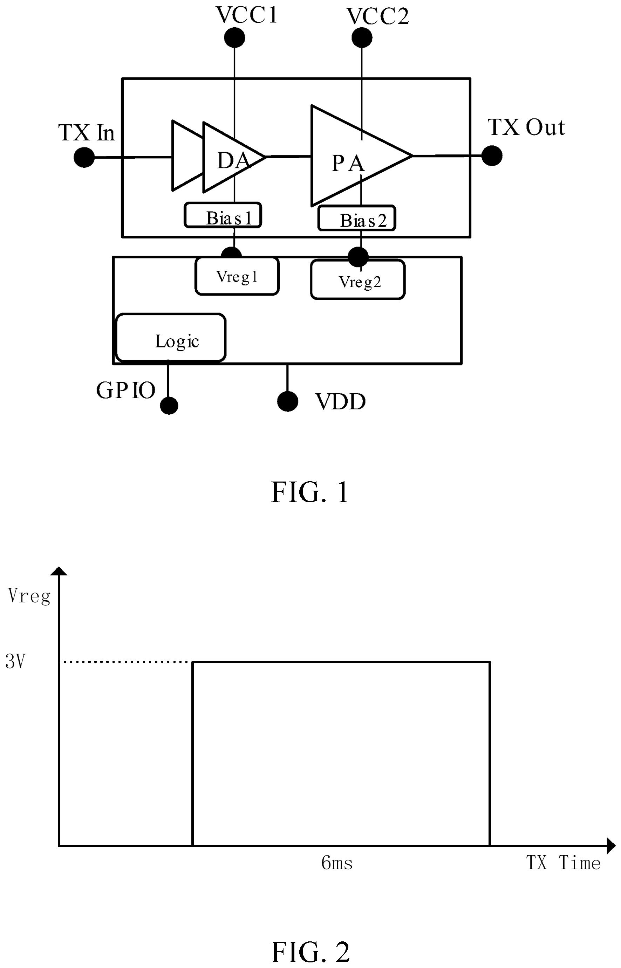

As shown in FIG. 1, a typical radio frequency front-end module in the existing technology includes a driving amplifier DA and a bias circuit Bias1 thereof, a power supply Vreg1, a power amplifier PA and a bias circuit Bias2 thereof, a power supply Vreg2 thereof, and a logic circuit unit Logic. When a GPIO interface provides a TX logic control signal, as shown in FIG. 2, the power supplies Vreg1 and Vreg2 start to provide constant voltages, and the driving amplifier DA and the power amplifier PA start to work, to enter a TX mode. The bias circuits Bias1 and Bias2 have temperature coefficients. The bias circuits have temperature compensation functions, to compensate for gain changes caused by temperature increase during working of the driving amplifier DA and the power amplifier PA, so as to keep the output power constant.

Typically, in a circuit design, the value of the temperature coefficient is controlled by adjusting circuit parameters of the bias circuits Bias1 and Bias2, or relative positions of the bias circuits Bias1 and Bias2 away from the layout of the driving amplifier DA and the power amplifier PA are controlled to sense a temperature change, so as to adjust the temperature compensation effect. The power supplies Vreg1 and Vreg2 are implemented by an LDO circuit, and provide a constant voltage or current to the driving amplifier DA and the power amplifier PA.

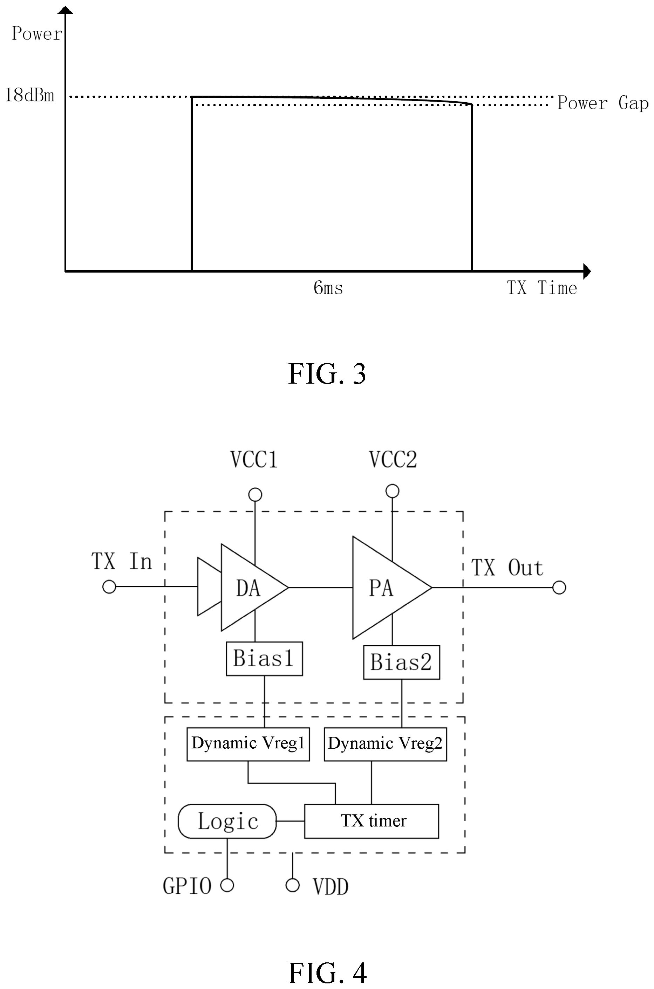

When the radio frequency front-end module is in the TX mode, as shown in FIG. 3, an x-coordinate is a TX working time, and a y-coordinate is a power of TX transmission under a fixed input. When the working time reaches 6 milliseconds (ms), a change in an output power is defined as a power gap. For a requirement on the DEVM of the WiFi 7, an absolute value of the power gap needs to be controlled at 0.05 dB. The reason why the power gap is generated is that during a TX working period, heat generated by the driving amplifier DA and the power amplifier PA causes a temperature rise. For the radio frequency front-end module of an HBT process, when the temperature rises, a gain decreases, and when the power of the TX input is constant, the output power decreases.

To resolve the foregoing problems existing in the existing technology, in the present invention, dynamic compensation is used to dynamically compensate for a change in the output power caused by a temperature change within a PA working cycle, thereby ensuring that the DEVM meets the requirements of the WiFi 7.

In a first embodiment of the present invention, as shown in FIG. 4, a radio frequency front-end module for optimizing a dynamic error vector magnitude includes: a driving amplifier DA, configured to perform gain amplification on an input radio frequency signal; a first bias circuit Bias1, configured to provide a bias voltage for the driving amplifier DA; a first dynamic power supply Vreg1, configured to provide a dynamic supply voltage to the first bias circuit Bias1; a power amplifier PA, configured to perform power amplification on a radio frequency signal; a second bias circuit Bias2, configured to provide a bias voltage for the power amplifier PA; a second dynamic power supply Vreg2, configured to provide a dynamic power supply voltage to the second bias circuit Bias2; and a logic circuit Logic, configured to generate a logic control signal according to a received baseband control signal, to control a working status of a related unit; and a TX timer, configured to record a TX working time. A radio frequency signal input end terminal TX_In is connected to an input end of the driving amplifier DA, an output end of the driving amplifier DA is connected to an input end of the power amplifier PA, and an output end of the power amplifier PA is connected to a radio frequency signal output end TX_Out. An input end GPIO of the baseband control signal is connected to an input end of the logic circuit Logic, an output end of the logic circuit Logic is connected to a control end of the TX timer, and an output end of the TX timer is separately connected to control ends of the first dynamic power supply Vreg1 and the second dynamic power supply Vreg2. An output end of the first dynamic power supply Vreg1 is connected to a power supply end of the first bias circuit Bias1, and an output end of the first bias circuit Bias1 is connected to a bias end of the driving amplifier DA. An output end of the second dynamic power supply Vreg2 is connected to a power supply end of the second bias circuit Bias2, and an output end of the second bias circuit Bias2 is connected to a bias end of the power amplifier PA.

When the logic circuit Logic receives, from a GPIO port, a control signal of a TX instruction sent by a baseband, the logic circuit Logic generates a logic control signal to control a related unit to enter a TX working mode, and a TX timer starts timing, and when a first time t1, a second time t2, a third time t3, ..., and an n^{th} time tn are respectively reached, the logic circuit Logic controls the first dynamic power supply Vreg1 and the second dynamic power supply Vreg2 to sequentially output a first voltage V1, a second voltage V2, a third voltage V3, ..., and an n^{th} voltage Vn respectively, to the first bias circuit Bias1 and the second bias circuit Bias2 sequentially. n is a positive integer, and the n^{th} time tn is less than a TX working time, that is, less than a packet length duration of a transmit signal. In a TX working time, a power supply voltage of the first bias circuit Bias1 and the second bias circuit Bias2, that is, an output voltage of the first dynamic power supply Vreg1 and the second dynamic power supply Vreg2 dynamically change over a time period, and are configured to provide different bias voltages for the driving amplifier DA and the power amplifier PA to change over time, to adjust a gain change in the TX working mode.

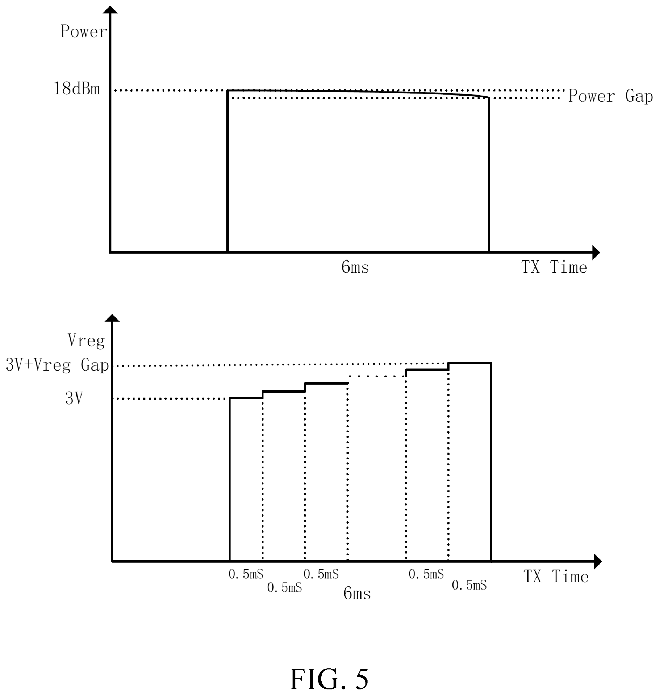

As shown in FIG. 5, when the output power decreases as the TX working time increases, it may be designed that each time when the TX timer expires after a time period of Δt, voltages respectively output by the first dynamic power supply Vreg1 and the second dynamic power supply Vreg2 are controlled to increase by ΔV1, to compensate for the decrease in the output power. The voltage increase amount ΔV1 may be set according to the power gap. As shown in FIG. 5, the time period Δt is 0.5 ms, as the time gradually increases, the first voltage V1, the second voltage V2, the third voltage V3, ..., and the n^{th} voltage Vn sequentially ascend by ΔV1, and a difference between output power corresponding to a maximum voltage and a minimum voltage is the power gap.

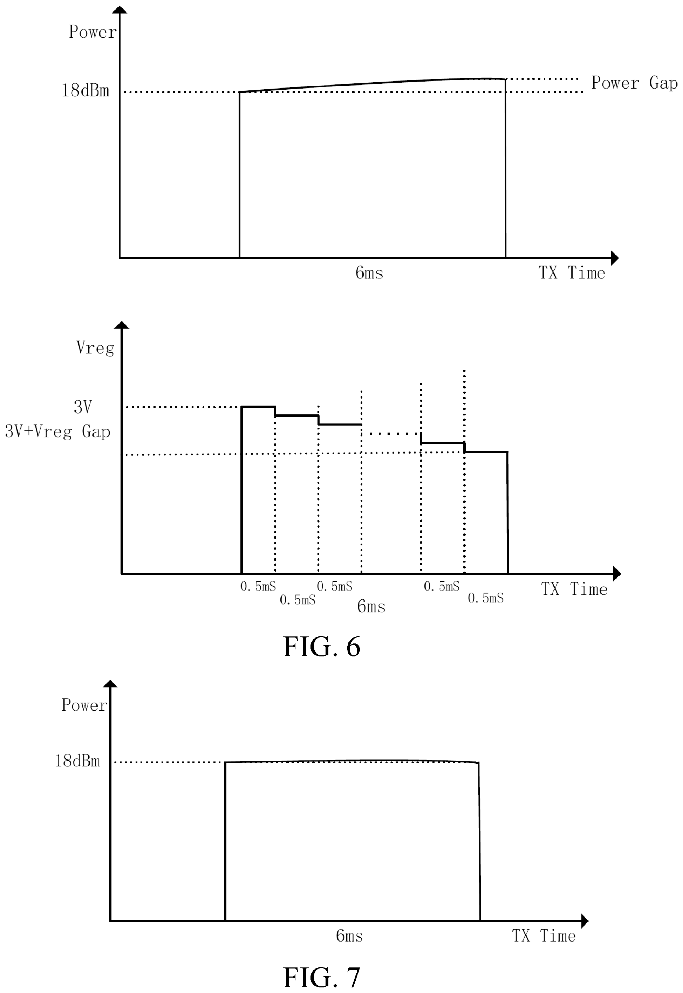

As shown in FIG. 6, when the output power increases as the TX working time increases, it may be designed that each time when the TX timer expires after a time period of Δt, voltages respectively output by the first dynamic power supply Vreg1 and the second dynamic power supply Vreg2 are controlled to decrease by ΔV2, to compensate for the increase in the output power. The voltage reduction amount ΔV2 may be set according to the power gap. As shown in FIG. 6, the time period Δt is 0.5 ms, as the time gradually increases, the first voltage V1, the second voltage V2, the third voltage V3, ..., and the n^{th} voltage Vn sequentially descend by ΔV2, and a difference between output power corresponding to a maximum voltage and a minimum voltage is the power gap.

After the foregoing dynamic compensation is performed on the power supply of the bias circuit, as shown in FIG. 7, the power gap between the output power may be controlled to be within 0.05 dB, to satisfy the requirement on the DEVM of the WiFi 7.

It should be noted that, the first dynamic power supply Vreg1 is controlled to sequentially output the first voltage V1, the second voltage V2, the third voltage V3, ..., and the n^{th} voltage Vn, and the second dynamic power supply Vreg2 sequentially outputs the first voltage V1, the second voltage V2, the third voltage V3, ..., and the n^{th} voltage Vn. Voltages corresponding to the first voltage V1, the second voltage V2, the third voltage V3, ..., and the n^{th} voltage Vn in a same time period may be equal or not equal. Alternatively, according to a specific circuit condition, one of the first dynamic power supply Vreg1 and the second dynamic power supply Vreg2 may be designed as a power supply of a dynamic output, and the other power supply is a power supply of a fixed output.

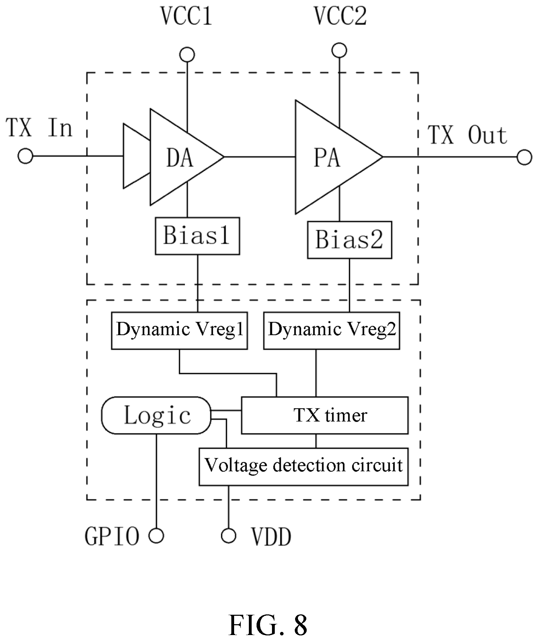

In a second embodiment of the present invention, as shown in FIG. 8, a radio frequency front-end module for optimizing a dynamic error vector magnitude includes: a driving amplifier DA, a first bias circuit Bias1, a first dynamic power supply Vreg1, a power amplifier PA, a second bias circuit Bias2, a second dynamic power supply Vreg2, a logic circuit Logic, a TX timer, and a voltage detection circuit. Different from the first embodiment, a voltage detection circuit is added. An input end of the voltage detection circuit is connected to the power supply VDD, and an output end is respectively connected to the logic circuit Logic and the TX timer. The voltage detection circuit is configured to detect a voltage of the power supply VDD, and dynamically adjust the power supply voltage of the bias circuit to an application environment of the power supply voltage VDD of different values of the application end.

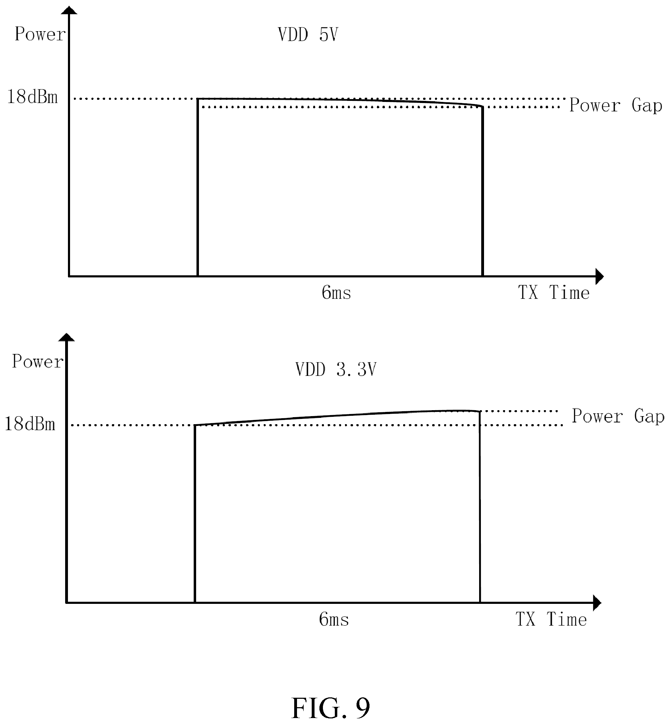

As shown in FIG. 9, when the voltage of the power supply VDD is relatively high (that is, higher than the first threshold), it is assumed that VDD = 5 V, the temperature of the circuit is relatively high, and the output power decreases as the TX working time increases; when the voltage of the power supply VDD is relatively low (that is, lower than the second threshold), it is assumed that VDD = 3.3 V, the temperature of the circuit is relatively low, and the output power increases as the TX working time increases. Therefore, the voltage detection circuit is configured to detect the voltage value of the power supply VDD, thereby dynamically adjusting the compensation manner of the power supply voltage of the bias circuit.

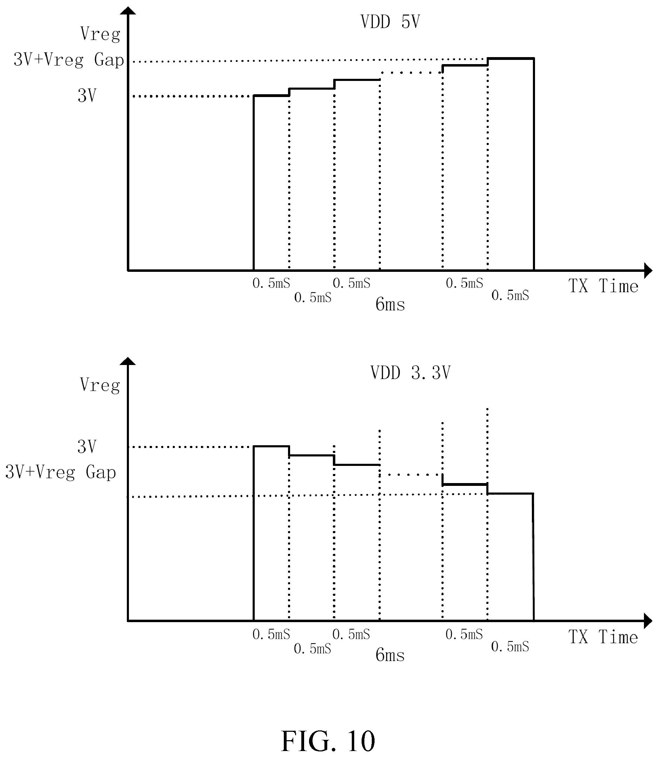

As shown in FIG. 10, when the voltage of the power supply VDD is relatively high (that is, higher than the preset first threshold), a compensation manner in which the output voltage of the first dynamic power supply Vreg1 and/or the second dynamic power supply Vreg2 sequentially ascends by ΔV1 as the TX working time increases is used. When the voltage of the power supply VDD is relatively low (that is, lower than the preset second threshold), a compensation manner in which the output voltage of the first dynamic power supply Vreg1 and/or the second dynamic power supply Vreg2 sequentially descends by ΔV2 as the TX working time increases is used. The power gap between the output power is controlled to be within 0.05 dB, to satisfy the requirement on the DEVM of the WiFi 7.

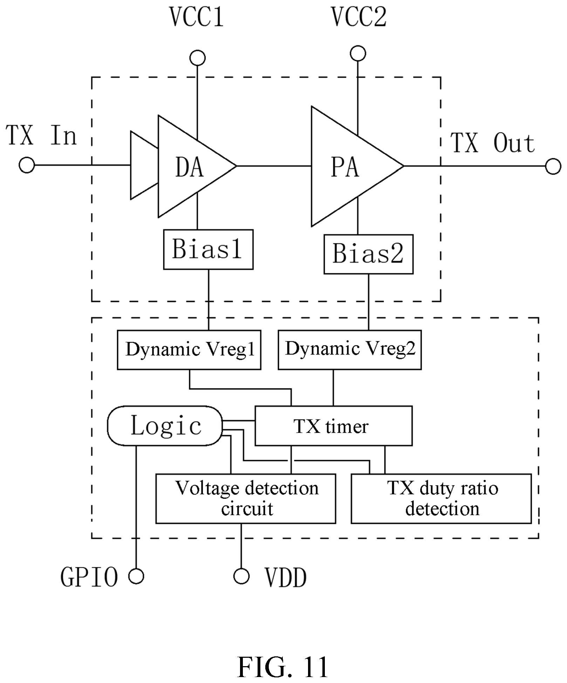

In a third embodiment of the present invention, as shown in FIG. 11, a radio frequency front-end module for optimizing a dynamic error vector magnitude includes: a driving amplifier DA, a first bias circuit Bias1, a first dynamic power supply Vreg1, a power amplifier PA, a second bias circuit Bias2, a second dynamic power supply Vreg2, a logic circuit Logic, a TX timer, a voltage detection circuit, and a TX duty ratio detection circuit. Different from the second embodiment, the TX duty ratio detection circuit is added. The TX duty ratio detection circuit is separately connected to the logic circuit Logic and the TX timer, and is configured to detect a duty ratio of TX transmission in a TDD working mode, so that dynamic adjustment of the power supply voltage of the bias circuit is adapted to an application environment of different TX duty ratios of an application end.

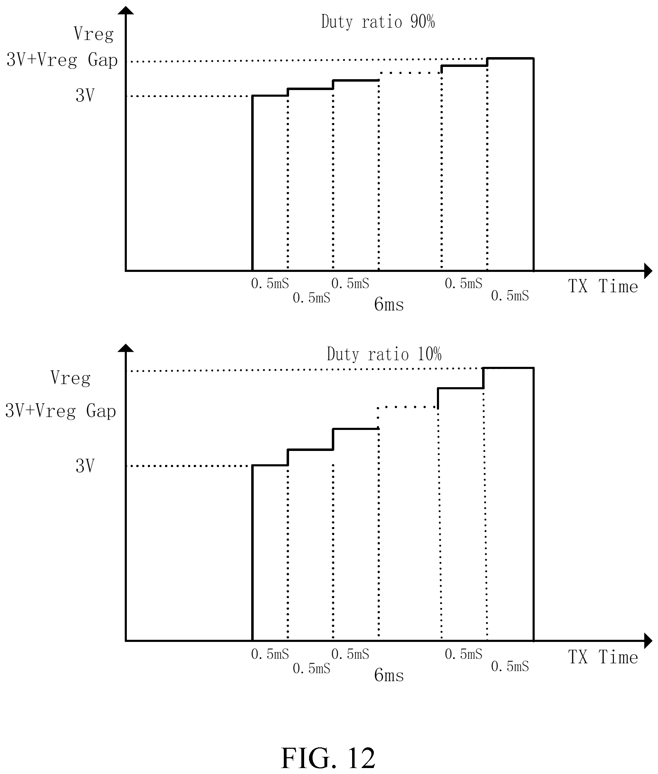

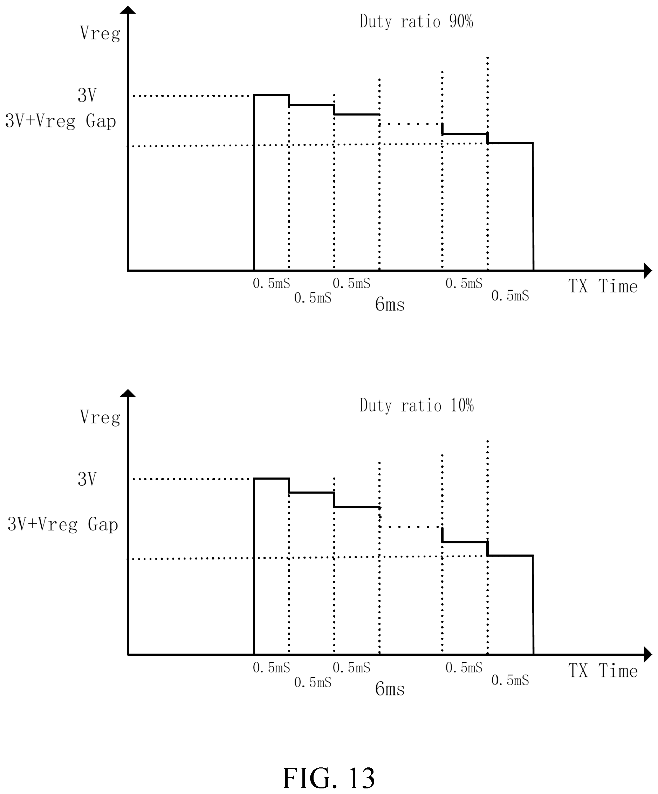

As shown in FIG. 12 and FIG. 13, for two cases in which the output power decreases or increases as the TX working time increases, the compensation magnitude of the dynamic power supply voltage that is output by the at least one dynamic power supply of the first dynamic power supply and the second dynamic power supply according to a plurality of set time periods varies inversely with the TX duty ratio that is detected by the TX duty ratio detection circuit. Specifically, when the TX duty ratio detected by the TX duty ratio detection circuit is relatively small (that is, lower than the preset third threshold), it is assumed that the duty ratio is 10%, a larger compensation magnitude by which the output voltage of the first dynamic power supply Vreg1 and/or the second dynamic power supply Vreg2 sequentially ascends or descends as the TX working time increases needs to be used. When the TX duty ratio detected by the TX duty ratio detection circuit is large (that is, higher than a preset fourth threshold), it is assumed that the duty ratio is 90%, a smaller compensation magnitude by which the output voltage of the first dynamic power supply Vreg1 and/or the second dynamic power supply Vreg2 sequentially ascends or descends as the TX working time increases needs to be used.

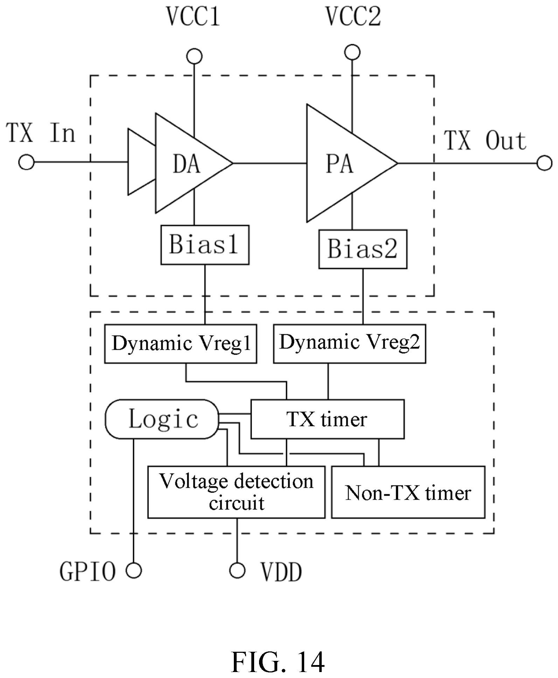

In a fourth embodiment of the present invention, as shown in FIG. 14, a radio frequency front-end module for optimizing a dynamic error vector magnitude includes: a driving amplifier DA, a first bias circuit Bias1, a first dynamic power supply Vreg1, a power amplifier PA, a second bias circuit Bias2, a second dynamic power supply Vreg2, a logic circuit Logic, a TX timer, a non-TX timer, and a voltage detection circuit. Different from the second embodiment, a non-TX timer is added. The non-TX timer is respectively connected to the logic circuit Logic and the TX timer, and is configured to record a time of a non-TX working state. The dynamic adjustment of the power supply voltage of the bias circuit is made to adapt to an application environment of different TX duty ratios of the application end. The TX timer and the non-TX timer may be implemented by using a same timer.

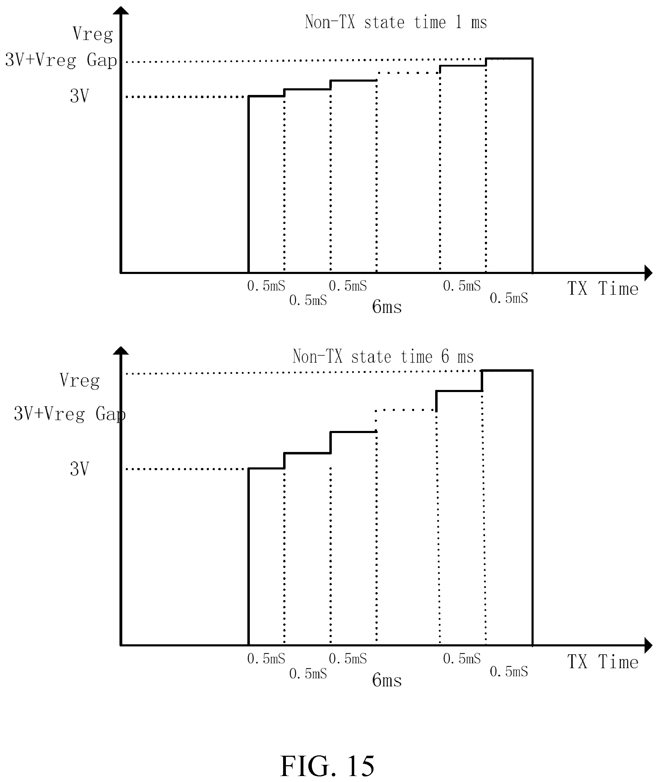

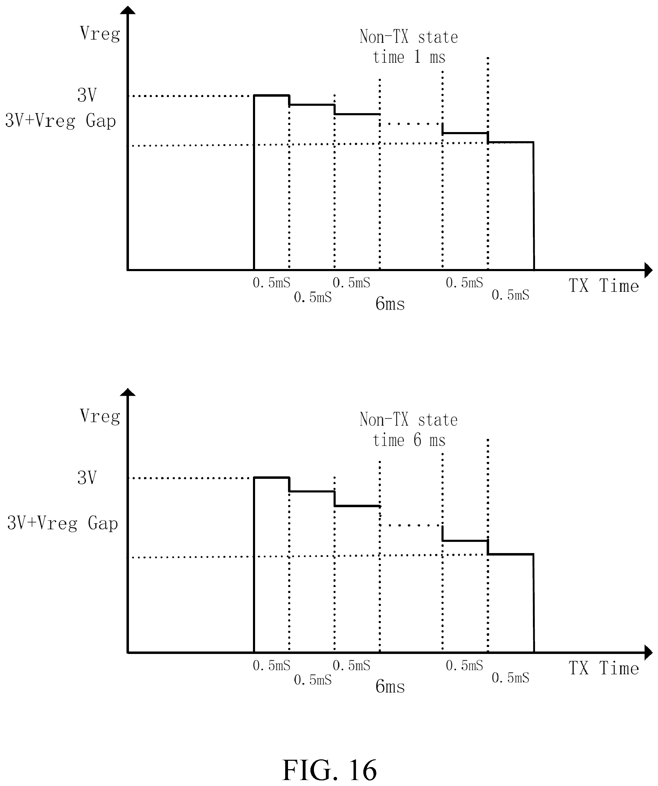

As shown in FIG. 15 and FIG. 16, for two cases in which the output power decreases or increases as the TX working time increases, the compensation magnitude of the dynamic power supply voltage that is output by the at least one dynamic power supply of the first dynamic power supply and the second dynamic power supply according to a plurality of set time periods varies positively with the time of the non-TX working state recorded by the non-TX timer. Specifically, when the time of the non-TX working state recorded by the non-TX timer is relatively small (that is, less than a preset fifth threshold), it is assumed that the time of the non-TX working state is 1 ms, a smaller compensation magnitude by which the output voltage of the first dynamic power supply Vreg1 and/or the second dynamic power supply Vreg2 sequentially ascends or descends as the TX working time increases needs to be used. When the time of the non-TX working state recorded by the non-TX timer is relatively large (that is, higher than a preset sixth threshold), it is assumed that the time of the non-TX working state is 6 ms, a larger compensation magnitude by which the output voltage of the first dynamic power supply Vreg1 and/or the second dynamic power supply Vreg2 sequentially ascends or descends as the TX working time increases needs to be used. In addition, when the time of the non-TX working state reaches a maximum value Tmax, the compensation voltage difference of the output voltage of the first dynamic power supply Vreg1 and/or the second dynamic power supply Vreg2 also reaches a maximum value.

In the foregoing four embodiments, the first dynamic power supply Vreg1 and the second dynamic power supply Vreg2 that supply power to the bias circuit are used, and the gain change in the TX working mode is adjusted according to different control signals. In other embodiments of the present invention, a technical solution of a dynamically output end bias circuit in combination with a fixed output end bias power supply may alternatively be used, to adjust a gain change in the TX working mode according to different control signals. The following describes this solution in detail with reference to the first embodiment and the second embodiment.

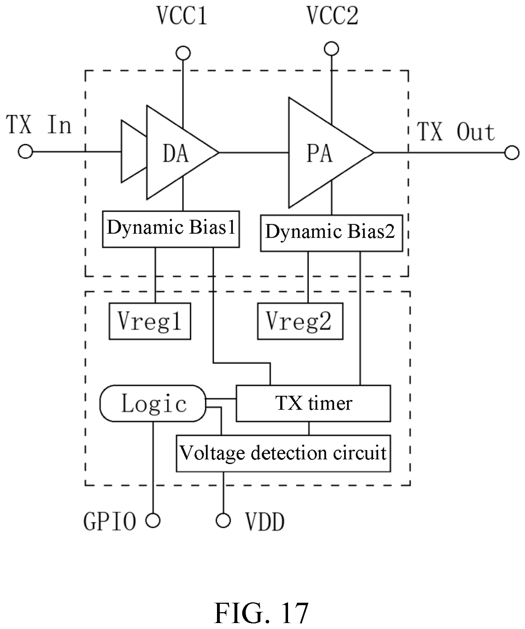

In a fifth embodiment of the present invention, as shown in FIG. 17, a radio frequency front-end module for optimizing a dynamic error vector magnitude includes: a driving amplifier DA, a first dynamic bias circuit Bias1, a first bias power supply Vreg1, a power amplifier PA, a second dynamic bias circuit Bias2, a second bias power supply Vreg2, a logic circuit Logic, a TX timer, and a voltage detection circuit. The first bias power supply Vreg1 and the second bias power supply Vreg2 are fixed output power supplies, and respectively provide power supplies for the first dynamic bias circuit Bias1 and the second dynamic bias circuit Bias2. An output end of the voltage detection circuit is separately connected to the logic circuit Logic and the TX timer, and an output end of the TX timer is separately connected to control ends of the first dynamic bias circuit Bias1 and the second dynamic bias circuit Bias2.

The voltage detection circuit is configured to detect a value of a voltage of the power supply VDD, and output a detection signal to the logic circuit Logic and the TX timer. For the two cases in which the output power decreases or increases as the TX working time increases, the logic circuit Logic sends a control signal by using the TX timer to separately control the first dynamic bias circuit Bias1 and the second dynamic bias circuit Bias2, to output a bias current or a voltage that sequentially ascends or descends as the TX working time increases, so as to dynamically adjust a compensation manner of the bias circuit, and control a power gap between the output power to be within 0.05 dB, to satisfy the requirement on the DEVM of the WiFi 7.

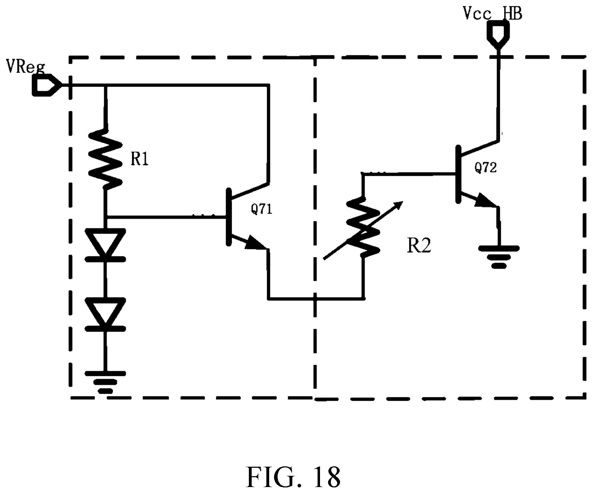

As shown in FIG. 18, the first dynamic bias circuit Bias1 and the second dynamic bias circuit Bias2 may use an adjustable resistance R2 or another adjustable element, to dynamically adjust an output bias current or voltage.

It should be noted that, the first dynamic bias circuit Bias1 and the second dynamic bias circuit Bias2 may further be designed, according to a specific circuit situation, as one of the first dynamic bias circuit Bias1 and the second dynamic bias circuit Bias2 being a fixed output end bias circuit, and the other one thereof being a dynamic output end bias circuit.

As can be seen from the analysis and description of the foregoing embodiments, according to the radio frequency front-end module for optimizing a dynamic error vector magnitude provided in the embodiments of the present invention, dynamic compensation is performed, by using a technical solution of dynamic voltage compensation, for a change in the output power caused by a temperature change within a PA working cycle, so that the DEVM is ensured to satisfy the requirements of the WiFi 7.

The radio frequency front-end module for optimizing a dynamic error vector magnitude provided in the embodiments of the present invention can be used in an electronic device, and used as an important constituent part of a communication component. The electronic device herein refers to a computer device that may be used in a mobile environment and supports various communication standards such as GSM, EDGE, CDMA, TD_SCDMA, WCDMA, TDD _LTE, FDD_LTE, and NR, and includes a mobile phone, a laptop, a tablet, an in-vehicle computer, and the like. In addition, the technical solutions provided in the present invention are also applicable to cases of other radio frequency integrated circuit applications, such as a communications base station and an intelligent network automobile.

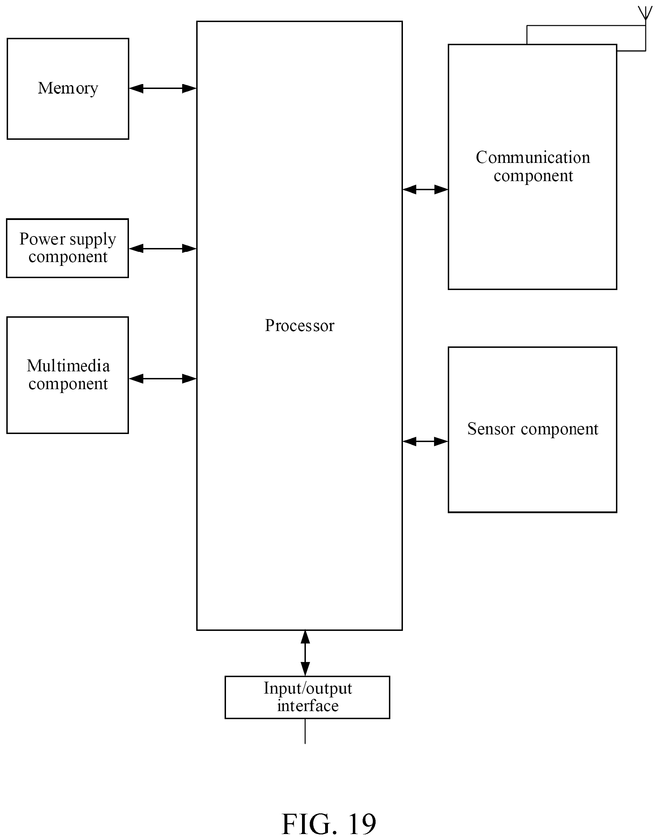

As shown in FIG. 19, the electronic device includes at least a processor, a memory, and a communication component, and may further include a sensor component, a power supply component, a multimedia component, and an input/output interface according to an actual requirement. The memory, the communication component, the sensor component, the power supply component, the multimedia component, and the input/output interface are all connected to the processor. The memory may be a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, or the like. The processor may be a central processing unit (CPU), a graphic processing unit (GPU), a field programmable gate array (FPGA), an application-specific integrated circuit (ASIC), a digital signal processing (DSP) chip, or the like. Other communication components, sensor components, power supply components, multimedia components, and the like may all be implemented by using common components, which are not specifically described herein.

To sum up, compared with the existing technology, according to the radio frequency front-end module for optimizing a dynamic error vector magnitude provided in the embodiments of the present invention, dynamic compensation is performed, by using a technical solution of dynamic voltage compensation, for a change in the output power caused by a temperature change within a PA working cycle, thereby ensuring that the DEVM meets the requirements of the WiFi 7. In addition, the problem that temperature compensation requirements are inconsistent due to different PA temperature changes in different packages, different layouts, different voltages, and different TX duty ratios is resolved, thereby shortening a product research and development cycle. Therefore, the radio frequency front-end module for optimizing a dynamic error vector magnitude provided in the embodiments of the present invention has beneficial effects such as skillful and proper structural design, low design costs, and excellent circuit performance.

It should be noted that the foregoing plurality of embodiments are merely examples, the technical solutions of the embodiments may be combined, and each unit circuit may be implemented by using a corresponding circuit in the existing technology, and all fall within the protection scope of the present invention.

It should be noted that the terms "first" and "second" mentioned below are merely used for a purpose of description and shall not be construed as indication or implication of relative importance or implicit indication of the quantity of indicated technical features. Therefore, a feature limited by "first" or "second" may explicitly or implicitly include one or more of the features. In the description of the present invention, the meaning of "a plurality of" means two or more unless otherwise specified.

The foregoing describes in detail the radio frequency front-end module for optimizing a dynamic error vector magnitude and the electronic device provided in the present invention. Any obvious change made by a person of ordinary skill in the art to the present invention without departing from the essence of the present disclosure shall constitute a violation of the patent right of the present invention and shall take corresponding legal responsibility.

## Claims

1. A radio frequency front-end module for optimizing a dynamic error vector magnitude, comprising at least one transmit channel, wherein each transmit channel comprises:
a driving amplifier, configured to perform gain amplification on an input radio frequency signal, an input end of the driving amplifier being connected to a radio frequency signal input end, and an output end of the driving amplifier being connected to an input end of a power amplifier;
a first bias circuit, configured to provide a bias voltage to the driving amplifier, an output end of the first bias circuit being connected to a bias end of the driving amplifier;
a first dynamic power supply, configured to provide a power supply voltage for the first bias circuit, and an output end of the first dynamic power supply being connected to a power supply end of the first bias circuit;
a power amplifier, configured to perform power amplification on a radio frequency signal, an output end of the power amplifier being connected to a radio frequency signal output end;
a second bias circuit, configured to provide a bias voltage to the power amplifier, an output end of the second bias circuit being connected to a bias end of the power amplifier;
a second dynamic power supply, configured to provide a power supply voltage for the second bias circuit, an output end of the second dynamic power supply being connected to a power supply end of the second bias circuit;
a logic circuit, configured to generate a logic control signal according to a received baseband control signal to control a working status of a related unit; an input end of the logic circuit being connected to an input end of the baseband control signal, and an output end of the logic circuit being connected to a control end of a TX timer;
the TX timer, configured to record a TX working time, wherein
upon receiving a TX instruction, the logic circuit controls the transmit channel to enter a TX working mode, and the TX timer starts timing, and when a first time, a second time, a third time, ..., and an n^{th} time are respectively reached, at least one dynamic power supply of the first dynamic power supply and the second dynamic power supply sequentially outputs a first voltage, a second voltage, a third voltage, ..., and an n^{th} voltage respectively, to the first bias circuit and/or the second bias circuit, to dynamically compensate for a change in output power caused by a temperature change of the circuit, wherein n is a positive integer.

2. The radio frequency front-end module for optimizing a DEVM according to claim 1, wherein:
an output end of the TX timer is separately connected to control ends of the first dynamic power supply and the second dynamic power supply.

3. The radio frequency front-end module for optimizing a dynamic error vector magnitude according to claim 2, wherein:
when the output power decreases as the TX working time increases, at least one dynamic power supply of the first dynamic power supply and the second dynamic power supply sequentially outputs ascending first voltage, second voltage, third voltage, ..., and n^{th} voltage to the first bias circuit and/or the second bias circuit during a first time, a second time, a third time, ..., and an n^{th} time, respectively.

4. The radio frequency front-end module for optimizing a dynamic error vector magnitude according to claim 2, wherein:
when the output power increases as the TX working time increases, at least one dynamic power supply of the first dynamic power supply and the second dynamic power supply sequentially outputs descending first voltage, second voltage, third voltage, ..., and n^{th} voltage to the first bias circuit and/or the second bias circuit during a first time, a second time, a third time, ..., and an n^{th} time, respectively.

5. The radio frequency front-end module for optimizing a dynamic error vector magnitude according to claim 1, wherein:
the transmit channel further comprises a voltage detection circuit, an input end of the transmit channel being connected to a power supply VDD; and an output end of the transmit channel being separately connected to the logic circuit and the TX timer.

6. The radio frequency front-end module for optimizing a dynamic error vector magnitude according to claim 5, wherein:
when a voltage of the power supply VDD is higher than a first threshold, the output power decreases as the TX working time increases; and an output voltage of at least one dynamic power supply of the first dynamic power supply and the second dynamic power supply sequentially ascends as the TX working time increases, to be provided to the first bias circuit and/or the second bias circuit; and
when the voltage of the power supply VDD is lower than a second threshold, the output power increases as the TX working time increases; and the output voltage of the at least one dynamic power supply of the first dynamic power supply and the second dynamic power supply sequentially descends as the TX working time increases, to be provided to the first bias circuit and/or the second bias circuit.

7. The radio frequency front-end module for optimizing a dynamic error vector magnitude according to claim 1, wherein:
the transmit channel further comprises a TX duty ratio detection circuit, separately connected to the logic circuit and the TX timer; and configured to detect a duty ratio of TX transmission in a TDD working mode.

8. The radio frequency front-end module for optimizing a dynamic error vector magnitude according to claim 7, wherein:
when a TX duty ratio detected by the TX duty ratio detection circuit is less than a third threshold, a compensation magnitude by which the output voltage of the at least one dynamic power supply of the first dynamic power supply and the second dynamic power supply that sequentially ascends or descends as the TX working time increases is larger; and
when the TX duty ratio detected by the TX duty ratio detection circuit is higher than a fourth threshold, the compensation magnitude by which the output voltage of the at least one dynamic power supply of the first dynamic power supply and the second dynamic power supply that sequentially ascends or descends as the TX working time increases is smaller.

9. The radio frequency front-end module for optimizing a dynamic error vector magnitude according to claim 1, wherein:
the transmit channel further comprises a non-TX timer, respectively connected to the logic circuit and the TX timer, and configured to record a time of a non-TX working state.

10. The radio frequency front-end module for optimizing a dynamic error vector magnitude according to claim 9, wherein:
when the time of the non-TX working state recorded by the non-TX timer is less than a fifth threshold, a compensation magnitude by which the output voltage of the at least one dynamic power supply of the first dynamic power supply and the second dynamic power supply that sequentially ascends or descends as the TX working time increases is smaller; and
when the time of the non-TX working state recorded by the non-TX timer is higher than a sixth threshold, the compensation magnitude by which the output voltage of the at least one dynamic power supply of the first dynamic power supply and the second dynamic power supply that sequentially ascends or descends as the TX working time increases is larger.

11. The radio frequency front-end module for optimizing a dynamic error vector magnitude according to claim 1, wherein:
the first bias circuit and the second bias circuit in the transmit channel respectively use a first dynamic bias circuit and a second dynamic bias circuit; and
an output end of the TX timer is separately connected to control ends of the first dynamic bias circuit and the second dynamic bias circuit.

12. The radio frequency front-end module for optimizing a dynamic error vector magnitude according to claim 11, wherein:
when the output power decreases or increases as the TX working time increases, the logic circuit sends a control signal by using the TX timer, to control at least one dynamic bias circuit of the first dynamic bias circuit and the second dynamic bias circuit, to output a bias current or voltage that sequentially ascends or descends as the TX working time increases.

13. An electronic device, comprising a radio frequency front-end module for optimizing a dynamic error vector magnitude according to any one of claims 1 to 12.
